Europäisches Patentamt

European Patent Office

Office européen des brevets

(11) Publication number: **0 176 488**
**A1**

## EUROPEAN PATENT APPLICATION

(21) Application number: **85830226.8**

(22) Date of filing: **09.09.85**

(51) Int. Cl.⁴: **G 01 R 1/02**
**G 01 D 13/26**

(30) Priority: **21.09.84 IT 2275884**

(43) Date of publication of application:
**02.04.86 Bulletin 86/14**

(84) Designated Contracting States:
**DE FR GB**

(71) Applicant: **ISTRUMENTI DI MISURA C.G.S. S.p.A.**
**Via Marsala, 24**
**I-20052 Monza (Milan)(IT)**

(72) Inventor: **Fedrigo, Renzo**
**Via Iseo, 10**
**I-20052 Monza (Milan)(IT)**

(72) Inventor: **Confalonieri, Pietro**
**Via Edison, 17**
**I-20052 Monza (Milan)(IT)**

(74) Representative: **Vannini, Torquato et al,**
**JACOBACCI-CASETTA & PERANI S.p.A. 7 Via Visconti di**
**Modrone**
**I-20122 Milan(IT)**

(54) Instrument for measuring electrical quantities, having adjustable threshold detectors.

(57) An instrument for measuring electrical quantities includes an indicator module (5) with a pointer (6) movable relative to a dial (7), to the ends of which is applied the electrical quantity to be measured. The instrument has at least one threshold detector (8a, 8b) constituted by an adjustment member with variable electrical characteristics, for example a potentiometer, which can be adjusted by means of suitable operating members (22, 23) fixed immovably in the casing and electrically connected to the ends of the indicator module (5), and a flexible belt element (36, 37) kinematically connected to the operating members (22, 23), which is movably guided on the instrument and carries a cursor (9a, 9b) for displaying the threshold value set on the dial (7).

Fig-3

EP 0 176 488 A1

Instrument for measuring electrical quantities, having adjustable threshold detectors.

The present invention relates to an instrument for measuring electrical quantities, of the type comprising, in a box-shaped casing, an indicator module with a pointer movable relative to a dial, to the ends of which is applied the electrical quantity to be measured, and at least one threshold detector for the electrical qauntity with an indicator which is adjustably locatable on the dial.

In the electrical field, frequent use is made of measuring instruments provided with threshold detectors which, through accessory circuits, check that the quantity being dealt with is kept within predetermined levels, for example between a maximum and a minimum adjustable in a range between the limits of the instrument dial.

For a direct visual check of these threshold levels of the quantity measured, it is necessary for the detectors to be provided with an indicator which can be located on the instrument dial in correspondence with the selected threshold level.

Known measuring instruments which satisfy this requirement are generally provided with photocells having emitters and receivers respectively overlying and underlying the movable pointer of the instrument, which are movable on the dial and are intended to detect, through the interruption of the light signal sent from the emitter to the receiver, the passage of the movable pointer past the selected threshold level.

Alternatively, it is known to provide movable electrical contacts on the instrument dial which, when reached by the movable pointer of the instrument, close an electrical circuit indicating that the threshold value set has been reached.

In the first case, it is necessary for the instrument to have equipment which is movable on the dial and is formed by emitters and receivers, the considerable bulk of which renders problematical the checking of several threshold values, for example a maximum and a minimum, particularly if they are very close together, because of the physical interference between the movable equipment of each threshold detector.

Furthermore, the threshold detectors do not function in the event of a failure of the indicator module since the interpretation of the threshold value is linked directly to the reading taken by the indicator module.

In the second case, however, the movement of the movable pointer of the indicator module is limited by the position of the electrical contacts which do not allow the instrument to display measurements of the electrical quantity in question outside the range between the maximum threshold and the minimum threshold.

Moreover, in neither case is it possible to make instruments with removable dials, this latter characteristic being particularly appreciated by manufacturers in that it permits the stock-piling of a series of instruments with identical characteristics and their subsequent calibration by the insertion of a suitable dial in accordance with a customer's requirements.

The problem behind the present invention is that of devising an instrument for measuring electrical quantities, which is provided with adjustable threshold detectors and is able to overcome all 'the disadvantages mentioned with reference to the prior art.

This problem is solved by a measuring instrument of the aforesaid type which is characterised in that the at least one threshold detector includes an adjustment member with electrical characteristics which are variable by means of operating members mounted on an immovable support within the casing and connected electrically to the ends of the indicator module, and a flexible element kinematically connected to the operating members, which is movably guided on the support and carries a cursor for displaying on the dial the threshold value set by means of the adjustment member with variable electrical characteristics.

The characteristics and advantages of the invention will become more apparent from the detailed description of a measuring instrument according to the invention, illustrated by way of non-limiting example, with reference to the appended drawings, in which:

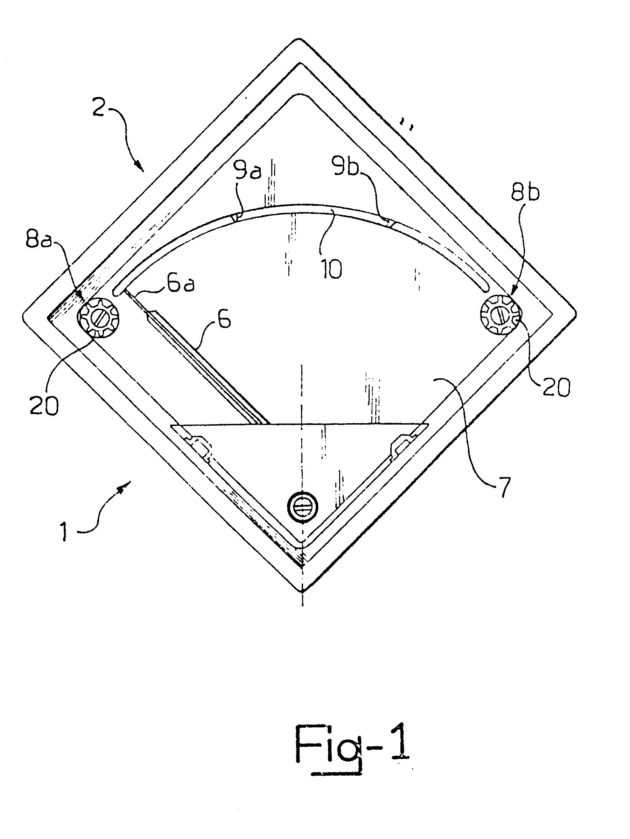

Figure 1 is a plan view of the instrument according to the invention;

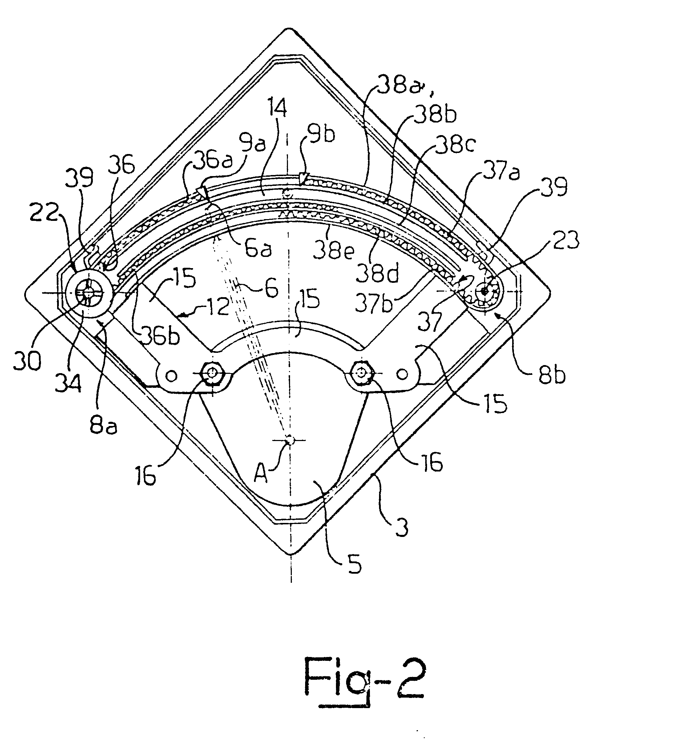

Figure 2 is a plan view of the instrument of Figure 1 the upper cover of which has been removed, and

Figures 3 to 5 are partial sectional views of the instrument according to the invention on an enlarged scale, showing successive stages in the insertion of its dial.

In the drawings, a measuring instrument according to the invention is generally indicated 1.' It comprises a box-shaped casing 2 formed by a terminal board 3 and a cover 4 joined together releasably by means of screws, not shown.

On the board 3 is mounted an indicator module 5, conventionally an ammeter, with a pointer 6 movable relative to a dial. The pointer 6 can oscillate about an axis A.

An electrical quantity to be measured is applied to the ends (not shown) of the indicator module 5, being supplied to the instrument 1 through conventional terminals, not shown, fixed to the board 3.

In this example, the instrument 1 has two threshold detectors, respectively a minimum 8a and a maximum 8b provided with respective cursors 9a and 9b, which are located in a zone underlying the dial 9 and are adjustably locatable relative thereto in a manner which will be explained below.

When the instrument is assembled, the cursors 9a, 9b are visible through an elongate curved window 10 in the dial 7.

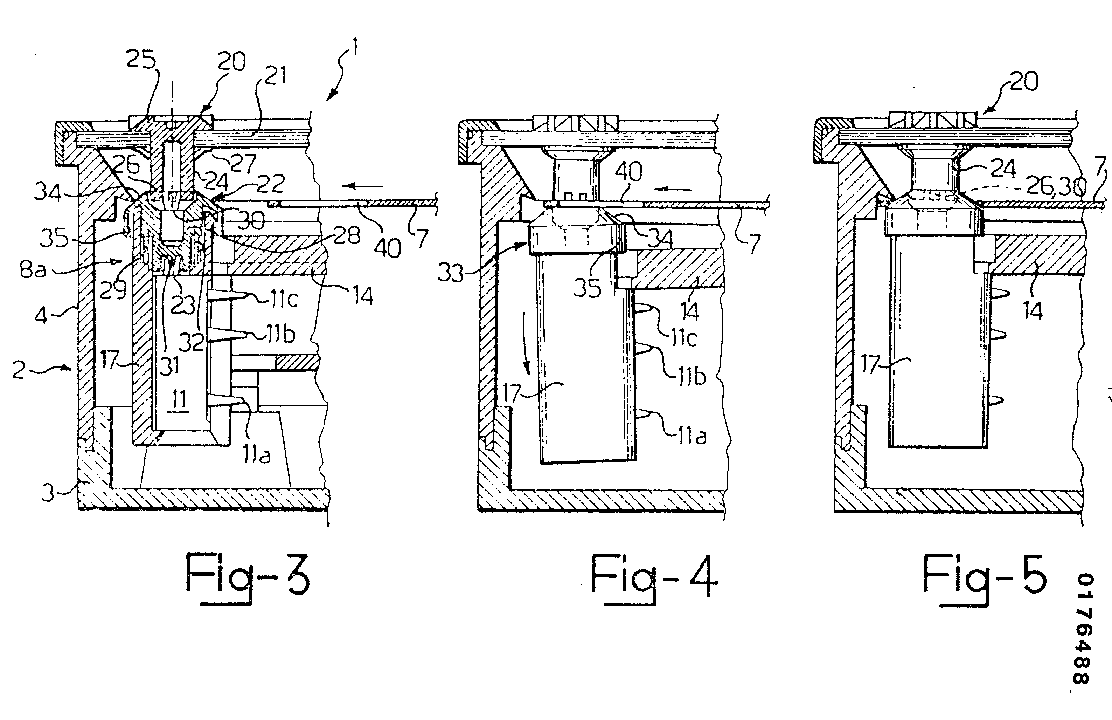

Figures 3 to 5 show only the minimum detector 8a in detail, since the maximum detector 8b is exactly the same apart from its positioning on the instrument 1.

- 5 -

**0176488**

The detector 8a consists of an adjustment member with variable electrical characteristics, such as a variable capacitor or preferably a potentiometer 11, conventionally provided with terminals 11a, 11b, 11c.

Two of the terminals (11a, 11c)' are electrically connected to the ends of the indicator module 5 or to another part of the instrument (for example, the terminals) from which the electrical quantity or a constant electrical signal is derived, and the remaining terminal (tapping terminal) is electrically connected to a signal-handling circuit, not shown, for example a comparator circuit of the type described in another patent application filed on the same date by the same Applicants and relating to a system for the two-way transmission of electrical signals along a conductor line.

A support 12 for the threshold detectors is also mounted in the casing 2; the support 12 is located on the opposite side of the dial 7 from the movable pointer 6 and includes a curved portion 14 having its centre on the axis A and extending close to the free end 6a of the movable pointer 6, and a portion 15 fixed to the instrument by screws 16.

At each end of the portion 14 is formed a respective housing 17 for receiving the corresponding potentiometer 11.

The entire support 12 is moulded in one piece from flexible plastics material for reasons which will become clearer later on in the present description.

Each potentiometer 11 is clamped in its corresponding housing 17 and is provided with operating members accessible from outside the casing 2. In the example in question, the operating members of each potentiometer comprise a knob 20 supported rotatably on the transparent face-plate 21 of the instrument casing 2, an intermediate member 22 rotatably mounted in the opening of each housing 17, and a shaft 23 forming a conventinal part of the potentiometer 11 for its regulation. The knob 20, the intermediate member 22 and the shaft 23 are mounted coaxially and are fast for rotation.

The knob 20 has a cylindrical body 24 provided, at its end outside the casing 2, with an enlargement 25 having tabs, notches or similar gripping means and, at its opposite end, a frontal coupling 26.

It is fixed for rotation in a through-hole in the plate 21 by means of a spring washer 27.

The intermediate member 22 has a central cylindrical body 28 which is rotatably engaged with slight interference in a seat 29 at the opening of the housing 27, axially opposite ends being provided respectively with a first frontal coupling 30 and a second frontal coupling 31 and its intermediate portion within the seat 29 being provided with a sprocket or gear 32.

The intermediate member 22 also has a cap 33 with a frusto-conical portion 34 tapering towards the knob 20 and a cylindrical edge portion 35 surrounding the opening of the housing 17 outside the seat 29.

Each of the sprockets 32 meshes with a flexible member, indicated 36 relative to the detector 8a and 37 relative to the detector 8b, for example a length of a conventional type of toothed belt used for kinematic transmissions.

From the corresponding sprocket 32, the member 36 (37) branches into two sections 36a, 36b (37a, 37b).

The cursor 9a (9b) is fixed releasably to the section 36a (37a) guided, in its turn, on the portion 14, and has an arrow pointer visible through the window 10 of the instrument dial 7.

The flexible members 36 and 37 are guided on the support 12 by tracks defined between corresponding walls 38a, 38b, 38c, 38d, 38e extending concentrically on the portion 14 of the support 12 with their centres of curvature on the axis A.

In order to provide a travel limit stop for the cursors at their end-of-scale positions, stops 39 rigid with the wall 38a at each of its opposite ends are also provided on the portion 14.

With regard to the dial 7 it should also be noted that it is provided with a pair of through-holes 40 for allowing engagement between the frontal couplings 26 and 30 of the operating members of each threshold detector, when the dial 7 is inserted in the instrument.

The adjustment of one or more threshold levels of the instrument 1 is carried out in the following manner: the intermediate member 22, and consequently its sprocket 32, is rotated by means of the knob 20 to effect the simultaneous adjustment of the potentiometer by virtue of the torsional coupling between the second frontal coupling 31 of the intermediate element and the shaft 23 of the potentiometer 11.

By means of the kinematic coupling between the sprocket 32 and the flexible element 36 (37), and in dependence on the sense of rotation of the knob 20, one of the sections 36a, 36b (37a, 37b) of the flexible element is returned towards the sprocket while the remaining one is thrust by an equal amount into the corresponding track and moves the cursor 9a (9b).

The corresponding cursor 9a, 9b displays on the dial of the instrument, through the window 10, a value proportional to the calibration of the potentiometer 11 set by the rotation of its shaft 23. Thus, one or more threshold values of the electrical quantity measured by the instrument 1 is preset and displayed without any interference with the position and functioning of the movable pointer 6 of the instrument.

The same electrical signal applied to the ends of the visual display unit is supplied to the terminals of the potentiometer 11.

The value of the electrical quantity measured, detected by the tapping terminal of the potentiometer 11, is thus compared with a predetermined threshold value by means of the handling circuit in order to pilot various users such as alarms, relays, safety devices and the like.

By virtue of the configuration described above, the dial 7 of the instrument 1 can be fitted into or removed from the assembled instrument at will.

This, in confirmation of what has been stated above, is particularly advantageous from the point of view of the manufacture of the instrument since it is not necessary to know the particular requirements of the customer at the beginning.

The dial 7 can be inserted in the instrument 1 through an aperture, not shown, formed in a suitable position in a side wall of the casing 2. During insertion in the casing 2, the dial 7 is guided so as to slide into the space between the movable pointer 6 and the support 12 and therefore does not interfere with the movable pointer of the indicator module nor with the support or the cursors 9a, 9b movable thereon. However, it does interfere with the frusto-conical portion 34 of each intermediate element 22.

The support 12, being flexible, is deformed resiliently with the consequent disengagement of the frontal couplings 26-30.

These frontal couplings re-engage each other when the dial 7 is inserted in its operative position and each hole 40 is located coaxially with the corresponding operating members of the potentiometer 11.

In this way, the invention solves the problems stated and achieves numerous other advantages among which, by virtue of the one-piece structure of the support 12 fixed to the instrument by the pair of screws 16, is the possibility of the ready conversion of a conventional instrument into an instrument with adjustable  threshold detectors.

This  can be achieved by providing the  same  instrument with  the  support  already  pre-assembled  with  its potentiometers,  operating  members  'and  cursors,  and providing knobs 20 on the face-plate 21.

- 11 -

**0176488**

<u>CLAIMS</u>

1. Instrument for measuring electrical quantities, comprising, in a box-shaped casing (2), an indicator module (5) with a pointer (6) movable relative to a dial (7), to the ends of which is applied the electrical quantity to be measured, and at least one threshold detector (8a, 8b) for the electrical quantity with an indicator which is adjustably locatable on the dial (7), characterised in that said at least one threshold detector (8a, 8b) includes an adjustment member (11) with electrical characteristics which are variable by means of operating members (20, 22, 23) mounted on an immovable support (12) within the casing (2) and connected electrically to the ends of the indicator module (5), and a flexible element (36, 37), kinematically connected to the operating members (20, 22, 23), which is movably guided on the support (12) and carries a cursor (9a, 9b) for displaying on the dial (7) the threshold value set by means of the adjustment member (11) with variable electrical characteristics.

2. Instrument according to Claim 1, characterised in that the operating members comprise, for each threshold detector (8a, 8b), a rotatable knob (20) mounted on the casing (2) of the instrument, an intermediate member (22) fast for rotation with an operating shaft (23) of the adjustment member (11) with variable electrical characteristics, and torsional coupling means (26, 30) engaged between the intermediate member (22) and the knob (20).

3. Instrument according to Claim 2, characterised in that the intermediate member (22) is rotatably mounted in a seat (29) in the support (12) at the opening of a housing (27) for the member (11) with variable electrical characteristics, and is provided with a sprocket (32) in an intermediate portion of the seat (29), the flexible element (36, 37) having teeth meshed with the sprocket (32) and guided in tracks defined on a curved portion (14) of the support (12), the cursor (9a, 9b) being slidably coupled with the curved portion (14) in correspondence with a window (10) in the dial (7).

4. Instrument according to Claim 2, characterised in that the dial (7) is releasably inserted in the casing (2) and has through-holes in correspondence with the operating members, and in that the intermediate member (22) has a cap (33) with a frusto-conical portion (34) which tapers towards the knob (20) and cooperates with the dial (7) for the insertion of the latter into its removal from the casing (2) by the disengagement of the torsional coupling means (26, 30) between the intermediate member (22) and the knob (20).

5. Instrument according to Claim 4, characterised in that the support (12) is formed of flexible material.

6. Instrument according to Claim 5, characterised in that the support (12) is moulded in one piece from plastics material.

7. Instrument according to Claim 1, characterised in that said at least one adjusting member (11) with variable electrical characteristics is a potentiometer.

Fig-1

0176488

Fig-2

Fig-3

Fig-4

Fig-5

0176488

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| Y | DE-U-1 900 782 (SIEMENS & HALSKE) * page 2; page 3, last two lines - page 4, line 17, figures 1, 2 * | 1 | G 01 R 1/02 G 01 D 13/26 |
| A | | 2,3,7 | |
| | --- | | |
| Y | US-A-3 145 339 (D.B. GARDNER) * claim 3 * | 1 | |
| A | | 7 | |
| | --- | | |
| A | DE-A-1 623 841 (SIEMENS) * claim 1; figure * | 3 | |
| | ----- | | |

**TECHNICAL FIELDS SEARCHED (Int Cl.4)**

G 01 R 1/02
G 01 D 13/22

The present search report has been drawn up for all claims

| Place of search BERLIN | Date of completion of the search 18-12-1985 | Examiner LEMMERICH J |
|---|---|---|